(19) Europäisches Patentamt
European Patent Office
Office européen des brevets

(11) Veröffentlichungsnummer: **0 355 581**
**A2**

(12) # EUROPÄISCHE PATENTANMELDUNG

(21) Anmeldenummer: **89114701.9**

(51) Int. Cl.⁴: **G03F 7/004**

(22) Anmeldetag: **09.08.89**

(30) Priorität: **17.08.88 DE 3827901**

(43) Veröffentlichungstag der Anmeldung:
**28.02.90 Patentblatt 90/09**

(84) Benannte Vertragsstaaten:
**AT BE CH DE FR GB IT LI NL**

(71) Anmelder: **HOECHST AKTIENGESELLSCHAFT**
**Postfach 80 03 20**
**D-6230 Frankfurt am Main 80(DE)**

(72) Erfinder: **Ruckert, Hans, Dr. Dipl.-Chem.**
**Erbsenacker 21**
**D-6200 Wiesbaden(DE)**

(54) **Positiv arbeitendes strahlungsempfindliches Gemisch und hiermit hergestelltes strahlungsempfindliches Aufzeichnungsmaterial.**

(57) Es wird ein positiv arbeitendes strahlungsempfindliches Gemisch beschrieben, das als wesentliche Bestandteile eine bei Bestrahlung eine starke Säure bildende Verbindung und ein in Wasser unlösliches, in organischen Lösemitteln und in wäßrig-alkalischen Lösungen lösliches oder quellbares Bindemittel und eine Verbindung enthält der allgemeinen Formel

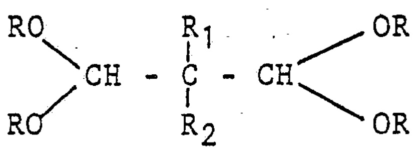

worin
R eine gegebenenfalls substituierte Alkylgruppe und
$R_1$ und $R_2$ gleich oder verschieden sind und Alkylgruppen mit 1 bis 6 Kohlenstoffatomen bedeuten.

Das Gemisch ist zur Herstellung von strahlungsempfindlichen Aufzeichnungsmaterialien wie Druckplatten oder Photoresists geeignet und zeichnet sich durch größere Flexibilität bei guter Entwicklerresistenz aus.

EP 0 355 581 A2

## Positiv arbeitendes strahlungsempfindliches Gemisch und hiermit hergestelltes strahlungsempfindliches Aufzeichnungsmaterial

Die Erfindung betrifft ein positiv arbeitendes, d. h. durch Bestrahlung löslich werdendes, strahlungsempfindliches Gemisch, das als wesentliche Bestandteile

a) eine bei Bestrahlung eine starke Säure bildende Verbindung,

b) eine Verbindung mit mindestens einer durch Säure spaltbaren C-O-C-Bindung, wie ein Acetal und

c) ein in Wasser unlösliches, in organischen Lösemitteln und in wäßrig-alkalischen Lösungen lösliches oder quellbares Bindemittel enthält und zur Herstellung von strahlungsempfindlichen Aufzeichnungsmaterialien, wie Photoresists, elektronischen Bauelementen und Druckplatten sowie zum Formteilätzen geeignet ist. Gemische der genannten Zusammensetzung sind z. B. in den US-A 3 779 778, DE-A 27 18 254, entsprechend US-A 4 247 611, DE-A 29 28 636, entsprechend US-A 4 311 782, EP-A 0 006 626, entsprechend US-A 4 250 247, und EP-A 0 042 562, entsprechend US-A 4 506 003, beschrieben.

Bei Belichtung dieser Materialien wird durch Photolyse der Verbindung a) Säure gebildet, die die Spaltung von C-O-C-Bindungen der Verbindung b) bewirkt, so daß im Ergebnis die belichteten Bereiche der lichtempfindlichen Schichten im Entwickler löslich werden. Diese Stoffgemische sind jedoch nicht frei von Nachteilen.

Die bisher verwendeten Polyacetale und Polyorthoester sind teilweise nicht leicht zugänglich und/oder besitzen die Eigenschaft - je nach den Kondensationsbedingungen - in unterschiedlicher Molekulargewichtsverteilung anzufallen. Dies beeinflußt sowohl die Herstellungskosten als auch die gewünschten Kopiereigenschaften, insbesondere die Konstanz der Lichtempfindlichkeit daraus hergestellter lichtempfindlicher Schichten. Die bekannten lichtempfindlichen Gemische können nur bis zu einem gewissen Mengenanteil säurespaltbare Verbindungen aufnehmen; als Hauptbestandteil enthalten sie in der Regel ein wasserunlösliches, in wäßrigen Alkalien lösliches Bindemittel, das dem Gemisch eine ausreichende Entwicklerresistenz verleiht. Dieser große Mengenanteil an alkalilöslichem Bindemittel, vorzugsweise an Phenolharz, bewirkt aber, daß Schichten aus dem Gemisch, insbesondere bei höheren Schichtdicken, relativ spröde sind und zum Reißen oder Splittern neigen.

Es war bisher die herrschende Auffassung, daß für eine gute bildmäßige Differenzierung möglichst viele spaltbare C-O-C-Bindungen, d. h. polymere Verbindungen vorliegen müssen, wobei die C-O-C-Bindungen bevorzugt in der Hauptkette des Polymeren liegen sollten, so daß aus einem Polymermolekül viele kleine wesentlich besser lösliche Bruchstücke gebildet werden.

In DE-A 37 25 741 wird ein strahlungsempfindliches Gemisch vorgeschlagen, das als Acetal unter anderem eine Verbindung der allgemeinen Formel

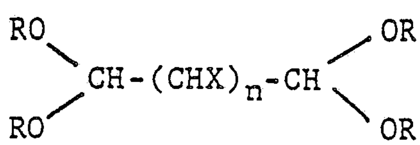

enthalten kann.

Es wurde nun gefunden, daß man, ausgehend von weiteren angebotenen technisch hergestellten Zwischenprodukten, neue substituierte Malondialdehydtetraacetale herstellen kann, die in positiv arbeitenden, lichtempfindlichen Schichten auch gut brauchbar sind.

Die Erfindung beschreibt deshalb weitere strahlungsempfindliche Gemische auf Basis von säurespaltbaren Verbindungen mit großer Strahlungsempfindlichkeit, die bei guter Entwicklerresistenz Kopierschichten mit besserer Flexibilität ergeben.

Erfindungsgemäß wird ein positiv arbeitendes strahlungsempfindliches Gemisch offenbart, das als wesentliche Bestandteile a) eine bei Bestrahlung eine starke Säure bildende Verbindung,

b) eine Verbindung mit mindestens einer durch Säure spaltbaren C-O-C-Bindung, wie ein Acetal und

c) ein in Wasser unlösliches, in organischen Lösemitteln und wäßrig-alkalischen Lösungen lösliches oder quellbares Bindemittel enthält.

Das erfindungsgemäße Gemisch ist dadurch gekennzeichnet, daß das Acetal eine Verbindung der allgemeinen Formel

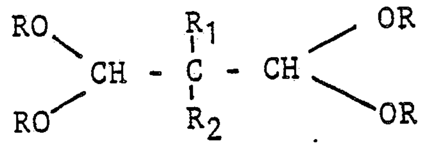

ist, worin
R eine gegebenenfalls substituierte Alkylgruppe und
$R_1$ und $R_2$ gleich oder verschieden sind und Alkylgruppen mit 1 bis 6 Kohlenstoffatomen bedeuten. Vorzugsweise bedeuten R eine durch Alkoxyl, Aryl, Aryloxyl oder Polyalkoxyl substituierte Alkylgruppe mit insgesamt jeweils 2 bis 20, besonders 2 bis 10 Kohlenstoffatomen und $R_1$ und $R_2$ gleiche oder verschiedene Alkylgruppen mit 1 bis 4 Kohlenstoffatomen.

Als aktinische Strahlung soll im Rahmen dieser Beschreibung jede Strahlung verstanden werden, deren Energie min destens der des kurzwelligen sichtbaren Lichts entspricht. Geeignet sind insbesondere kurzwellige bis langwellige UV-Strahlung, auch als Laserstrahlung, aber auch Elektronen- und Röntgenstrahlung.

Als flüssige Entwickler sind insbesondere schwach alkalische, wäßrige Lösungen, ggf. im Gemisch mit organischen Lösemitteln, zu verstehen.

Die Tetraacetale der allgemeinen Formel I leiten sich ab von dialkylsubstituierten Malondialdehyden und Monoalkoholen, bevorzugt primären Alkoholen. Geeignete Alkohole ROH sind solche, in denen R die folgende Bedeutung hat: Alkyl, Alkoxy-alkyl, Arylalkyl, Aryloxyalkyl und Polyalkoxyalkyl. Beispiele für geeignete Alkohole sind 2-Ethylbutanol, 2-n-Butoxyethanol, Benzylalkohol, 2-Phenoxyethanol und 2-(2-n-Butoxy-ethoxy)ethanol.

Die Verbindungen der beanspruchten allgemeinen Formel sind neu, mit der Ausnahme, wenn $R_1$ und $R_2$ Methyl und R Ethyl bedeuten (J. org. Chem. 25; 258 (1960)).

Analog wurden die Tetramethylacetale (R = $CH_3$) hergestellt, die als Ausgangsprodukte für die Umacetalisierungen unter Abspaltung von Methanol dienten.

Die erfindungsgemäßen spaltbaren Tetraacetale kann man durch Umacetalisierung der entsprechenden Tetramethyl-, Tetraethyl- oder gemischten Methyl-ethyl-acetale, bevorzugt der Tetramethylacetale, mit käuflichen Alkoholen herstellen unter Abdestillieren von vorzugsweise Methanol.

Diese Tetramethylacetale von Dialkylmalonaldehyden (3) werden nach folgender Reaktionsfolge hergestellt aus käuflichen

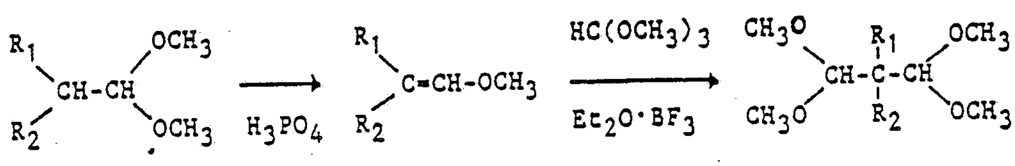


1 2 3

aliphatischen Monoaldehyden bzw. aus deren teils ebenfalls schon käuflichen Dimethylacetalen (1). Wenn die Dimethylacetale (1) nicht käuflich sind, werden sie nach bekannten Methoden bzw. Vorschriften aus Aldehyd und Methanol bzw. Orthoameisensäuremethylester hergestellt und durch Destillation gereinigt.

Erfindungsgemäß spaltbare Produkte (3) werden ausgehend von Aldehyden wie Isobutyraldehyd-dimethyl-acetal ($R_1$ und $R_2$ gleich Methyl), 2-Methylbutyraldehyddimethylacetal ($R_1$ Methyl, $R_2$ Ethyl), 2-Ethylbutyraldehyd-dimethylacetal ($R_1$ und $R_2$ Ethyl) und 2-Ethylhexanaldimethyl-acetal ($R_1$ Ethyl und $R_2$ Butyl) hergestellt. Isobutyraldehyd-diethylacetal konnte analog der Vorschrift in J. Chem. Soc. 1945, 597 hergestellt werden (Brechungsindex n = 1.394).

Die Synthese der Enolether (2) aus (1) erfolgt analog der in J. org. Chem. 25; 258 (1960) beschriebenen Methode durch Abspalten von Methanol mit 85 % Phosphorsäure als Katalysator und fraktionierte Destillation. Mit einer guten Kolonne lassen sich zunächst bei Normaldruck das Methanol, danach im Vakuum die Enolether abtrennen. In einigen Fällen wurde von einer Reindestillation abgesehen, da bei der Umsetzung der Enolether (2) zu den Dialkylmalondialdehydtetraacetalen (3) ohnehin nochmals fraktioniert destilliert wurde, bis die Ausgangsprodukte entfernt waren, s.a. Houben Weyl 6/1 d, S. 136.

Die Addition von Orthoestern an Enolether (2) zu den Methyl-(bzw. Ethyl)-Acetalen (3) verläuft mit Bortrifluorid-Etherat analog der gleichen Literaturvorschrift ebenfalls zufriedenstellend.

Insgesamt wurde bei allen Synthesen, außer Neutralstellen und Trocknen der gewünschten Fraktionen,

nur fraktioniert destilliert. Bei Wiederholungen kann man durch Wiedereinsetzen nicht umgesetzter abdestillierter Enolether- bzw. Orthoester-Fraktionen die Gesamtausbeute verbessern. Bei den höheralkyl-substituierten Derivaten wurde in der letzten Stufe (3) im Ölpumpenvakuum fraktioniert und der Kolbenrückstand nicht weiter gereinigt. Die Umacetalisierung dieser rohen höher substituierten Produkte z.B. Ethyl-butylmalonaldehydtetramethylacetal mit z.B. 2-Ethoxyethanol unter Abspaltung von Methanol führt zu noch weniger destillierbaren erfindungsgemäßen Substanzen. Ihre anwendungstechnische Brauchbarkeit in Positivschichten belegt auch die erfolgreich verlaufenen Synthesen.

Die neuen Substanzen als Ausgangsprodukte für die in Positivschichten beanspruchten neuen spaltbaren Tetraacetale wurden neben gaschromatographischen Kontrollen und IR-Spektren durch ihre Siedebereiche (Kp) und Brechungsindices ($n_D$) charakterisiert, die der folgenden Tabelle zu entnehmen sind.

TABELLE

| $R_1$ | $R_2$ | Aldehyd-diacetal 1 | Enolether 2 | Dialkylmalondialdehyd-tetraacetal 3 |
|---|---|---|---|---|
| $CH_3$ | $CH_3$ | 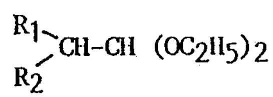 Kp 134-135 °C, $n_D$ = 1,394 | 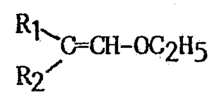 Kp 92-94 °C, $n_D$ = 1,406 | 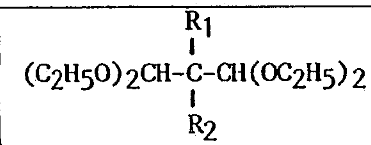 $Kp_{0,2}$ = 48-56°C, $n_D$=1,418 |
| $CH_3$ | $CH_3$ | 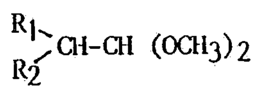 Kp 83°C, $n_D$ = 1,388 | 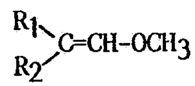 Kp≈99°C, $n_D$ = 1,3896 1,392 | 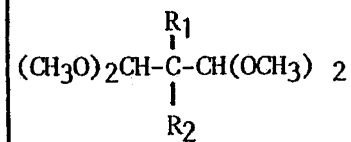 $Kp_{\sim 35}$ 94-98°C, $n_D$ = 1,419 ($C_{ber}$ 56,2% gef. ~ 56% $H_{ber}$ 10,4% gef.10-11%) |
| $CH_3$ | $C_2H_5$ | Kp 130°C $n_D$ = 1,398 | Kp 103°C, $n_D$ = 1,411 IR 1670 $cm^{-1}$ Vinyl-Proton | $n_D$ = 1,4255 |
| $C_2H_5$ | $C_2H_5$ | Kp~ 150°C $n_D$ = 1,408 $Kp_{100}$ ~ 88°C | Kp~ 120-128°C, $n_D$ = 1,421 IR 1695 $cm^{-1}$ | $n_D$ = 1,429 |
| $C_2H_5$ | $nC_4H_9$ | $Kp_{20}$ ~ 80°C, n = 1,418 | Kp 173-182°C, $n_D$ = 1,423 | $n_D$ = 1,432 |

Die erfindungsgemäßen Verbindungen wurden beim Erhitzen der Tetramethyl- bzw. -ethyl-acetale mit einem geringen Alkohol-Überschuß in Gegenwart eines sauren Katalysators wie Toluolsulfonsäure, oder vorteilhaft eines Montmorillonit-Ionenaustauschers, z.B. K10 der Südchemie, der nach Beendigung der Umacetalisierung abfiltriert werden kann, unter kontinuierlichem Abdestillieren von Methanol gebildet. Gegen Ende der Umacetalisierung wird, zweckmäßig unter Anwendung einer Fraktioniersäule, das restliche Methanol und dann unter Vakuum der destillierbare Überschuß an Ausgangskomponenten abgezogen. Im Ölpumpenvakuum können nur die Substanzen mit niederen Resten R, $R_1$ und $R_2$ destilliert werden, was keine befriedigende Methode ist. Daher werden die Substanzen undestilliert in den Schichten eingesetzt

und so unter ähnlichen Bedingungen verglichen.

In beiden Fällen mit Tetramethyl- und Tetraethylacetal, jeweils umacetalisiert mit 2-Ethoxyethanol, wo nach Abdestillieren von Methanol bzw. Ethanol in einer Kurzweg-Destillation bei ca. 0,2 Torr farbloses Endprodukt erhalten wurde, ergab die anwendungstechnische Prüfung, daß kein merklicher Unterschied zwischen dem farblosen Destillat und dem, nach Abdestillieren des Methanols und der Ausgangskomponenten, erhaltenen Rohprodukt besteht.

Ferner zeigt sich, daß der optimale Mengenanteil an spaltbarer Substanz in dem erfindungsgemäßen lichtempfindlichen Gemisch und damit die erreichbare Differenzierung zwischen belichteten und unbelichteten Schichtpartien in erhebli chem Maße von der verwendeten Alkoholkomponente, insbesondere ihrer Größe und Hydrophilie, und der Wechselwirkung mit dem Bindemittel abhängt.

Analog ist der Einfluß der Struktur der Dialdehydkomponente. Je größer die Alkylsubstituenten $R_1$ und $R_2$ sind, umso unpolarer werden die Produkte, alles jeweils verglichen auf Tetraacetale gleicher Alkohol-Komponente. Dies wirkt sich bei der Funktionsprüfung so aus, daß die Schichten weichere Konsistenz besitzen, langsamer aufentwickeln, aber auch relativ mehr Acetal, bezogen auf den Gesamtfeststoff, verwendet werden kann. Dadurch, daß mit den erfindungsgemäßen Tetraacetalen sowohl von der Alkylsubstitution des Malondialdehyds her als auch der Wahl der Alkoholkomponente viele Varianten möglich sind, steht eine große Auswahl brauchbarer spaltbarer Verbindungen zur Verfügung.

Der optimale Mengenanteil an Acetal in dem erfindungsgemäßen Gemisch liegt bei 25 - 60, vorzugsweise 30 - 40 Gewichtsprozent, bezogen auf Gesamtfeststof, im Vergleich zu ca. 15 - 25 Gewichtsprozent bei den bekannten oligomeren oder polymeren spaltbaren Verbindungen. Im Vergleich zu den Tetraacetalen der oben erwähnten DE-A 37 25 741, sind ähnliche Mengenanteile und bei $R_1$, $R_2$ = Alkyl mit mehr als 4 Kohlenstoffatomen eher noch höhere Anteile am günstigsten für die Gesamteigenschaften, d.h. mechanische Eigenschaften, Lichtempfindlichkeit, Entwickelbarkeit in verdünntem Alkali und Resistenz gegen Überentwicklung, Ätz-und Galvano-Bedingungen.

Die erfindungsgemäßen spaltbaren Verbindungen können allein oder im Gemisch und auch in Kombination mit bekannten säurespaltbaren Verbindungen eingesetzt werden. Auch ist es möglich, bei der Umacetalisierung bis zu etwa 30 % der Alkoholkomponente durch Diole zu ersetzen. Dabei entstehen neben monomeren auch oligomere bis polymere Acetale der eingesetzten Dialdehyde, was zu höherer Viskosität der Produkte führt. Diol-Anteile über etwa 50 % führen zu vernetzten Polyacetalen und damit zum Gelieren und zu Entwicklungsproblemen.

Zur Herstellung der erfindungsgemäßen positiv arbeitenden strahlungsempfindlichen Gemische werden die beschriebenen Acetale gemischt mit Substanzen, die photochemisch und bzw. oder durch Einwirkung von energiereicher Strahlung, besonders Elektronen- oder Röntgenstrahlung, Säuren bilden.

Die Gemische enthalten ferner ein polymeres, wasserunlösliches Bindemittel, das in organischen Lösemitteln löslich ist. Da sich als Entwicklerflüssigkeiten für die belichteten Kopierschichten mit Vorteil wäßrig-alkalische Lösungen einsetzen lassen und diese im allgemeinen gegenüber Entwicklern auf Basis organischer Lösemittel vorgezogen werden, werden solche Bindemittel verwendet, die in wäßrigen Alkalien löslich oder mindestens quellbar sind.

Die Art und Menge der wasserunlöslichen Bindemittel kann je nach Anwendungszweck verschieden sein; bevorzugt sind Anteile am Gesamtfeststoff zwischen 30 und 80, besonders bevorzugt 50 - 75 Gewichtsprozent.

Die bei vielen Positiv-Kopiermaterialien bewährten Phenolharze, vor allem Novolake, haben sich auch hier als besonders vorteilhaft erwiesen. Die Novolake können auch in bekannter Weise durch Umsetzung eines Teils ihrer Hydroxygruppen, z. B. mit Chloressigsäure, Isocyanaten, Epoxiden oder Carbonsäureanhydriden, modifiziert sein. Andere alkalilösliche Harze, wie Mischpolymerisate aus Maleinsäureanhydrid und Styrol, Vinylacetat und Crotonsäure, Methylmethacrylat und Methacrylsäure und dgl. sind ebenfalls als Bindemittel geeignet. Auch Mischpolymerisate von (Meth)acrylestern mit freien phenolischen OH-Gruppen sowie Homo-oder Mischpolymerisate von Vinylphenolen sind brauchbar.

Zusätzlich können noch zahlreiche andere Harze mitverwendet werden, die entweder wasserlöslich oder aber alkaliunlöslich sein können, z. B. Polyvinylacetate, Polyurethane, Polyacrylate, Polyvinylether und Polyvinylpyrrolidone, die selbst durch Comonomere modifiziert sein können, sowie hydrierte oder teilhydrierte Kolophoniumderivate. Der günstigste Anteil an diesen Harzen richtet sich nach den anwendungstechnischen Erfordernissen und dem Einfluß auf die Entwicklungsbedingungen und beträgt im allgemeinen nicht mehr als 20 Gewichtsprozent vom alkalilöslichen Harz. In geringen Mengen kann die lichtempfindliche Schicht für spezielle Erfordernisse wie Flexibilität, Haftung, Glanz etc. außerdem noch Substanzen wie Polyglykole, Celluloseether, z. B. Ethylcellulose, Netzmittel und feinteilige Pigmente enthalten.

Als strahlungsempfindliche Komponenten, die beim Bestrah len starke Säuren bilden bzw. abspalten, sind eine große Anzahl von bekannten Verbindungen und Mischungen, wie Diazonium-, Phosphonium-,

Sulfonium und Jodonium-Salze, Halogen-Verbindungen, o-Chinondiazidsulfochloride und Organometall-Organohalogen-Kombinationen geeignet.

An Diazonium-Salzen kommen die in der Diazotypie bekannten Verbindungen mit ausnutzbarer Absorption zwischen 300 und 600 nm in Frage. Bevorzugt werden Verbindungen, die keine basischen Substituenten enthalten.

Die genannten Oniumsalze werden in der Regel in Form ihrer in organischen Lösungsmitteln löslichen Salze eingesetzt, meist als Abscheidungsprodukt mit komplexen Säuren wie Borfluorwasserstoffsäure, Hexafluorphosphor-, Hexafluorantimon- und -arsensäure.

Grundsätzlich sind als halogenhaltige strahlungsempfindliche und Halogenwasserstoffsäure bildende Verbindungen alle auch als photochemische Radikalstarter bekannten organischen Halogenverbindungen, beispielsweise solche mit mehr als einem Halogentom an einem Kohlenstoffatom oder an einem aromatischen Ring, brauchbar. Beispiele sind in den US-A 3 515 552, und 3 779 778, der DE-C 26 10 842, entsprechend US-A 4 101 323 und DE-C 27 18 259, entsprechend US-A 4 189 323, beschrieben.

Die Menge des Säurespenders kann je nach seiner chemischen Natur und der Zusammensetzung des Gemischs ebenfalls sehr verschieden sein. Günstige Ergebnisse werden erhalten mit 0,1 bis 10, bevorzugt 0,2 bis 5 Gewichtsprozent, bezogen auf den Gesamtfeststoff. Besonders für Kopierschichten von Dicken über 10 µm empfiehlt es sich, relativ wenig Säurespender zu verwenden.

Schließlich können dem lichtempfindlichen Gemisch noch lösliche oder feinteilige dispergierbare Farbstoffe sowie je nach Anwendungszweck auch UV-Absorber zugesetzt werden. Als Farbstoffe haben sich die Triphenylmethanfarbstoffe, insbesondere in der Form ihrer Carbinolbasen, besonders bewährt. Zur Erhöhung des Bildkontrasts nach der Belichtung werden die in der EP-A 224 161 beschriebenen Polymethinfarbstoffe bevorzugt eingesetzt.

Geeignete Lösemittel für das erfindungsgemäße strahlungsempfindliche Gemisch sind Ketone wie Methylethylketon; chlorierte Kohlenwasserstoffe wie Trichlorethylen und 1,1,1-Trichlorethan, Alkohole wie n-Propanol, Ether wie Tetrahydrofuran, Alkoholether wie Propylenglykolmonoethylether und Ester wie Butylacetat oder 1-Ethoxy-propyl-2-acetat. Es können auch Gemische verwendet werden, die zudem noch für spezielle Zwecke Lösemittel wie Acetonitril, Dioxan oder Dimethylformamid enthalten können. Prinzipiell sind alle Lösemittel verwendbar, die mit den Komponenten nicht irreversibel reagieren.

Die Wahl der Lösemittel ist auf das vorgesehene Beschichtungsverfahren, die Schichtdicke und die Trocknungsvorrichtung abzustimmen. Dünne Schichten bis ca. 5 µm werden für Versuchsmengen vorzugsweise auf der Schleuder durch Aufgießen aufgetragen. Mit Lösungen bis zu ca. 40 % Feststoffgehalt sind so mit einmaligem Auftrag oder mit einer Streichrakel Schichtdicken von mehr als 60 µm erreichbar. Für beidseitige Beschichtung wird Tauchbeschichtung vorgezogen, wobei durch Verwendung von niedrigsiedenden Lösemitteln schnelles Antrocknen erreicht werden kann. Bandbeschichtung erfolgt durch Antragen mittels Walzen, Breitschlitzdüsen oder Sprühen; Einzelplatten können durch Gießerantrag (curtain-coater) beschichtet werden.

Bevorzugte Träger für Schichten von mehr als 10 µm Dicke sind Kunststoffolien, die dann als temporäre Träger für Transferschichten dienen. Dafür und für Farbfolien werden Polyesterfolien bevorzugt. Als Schichtträger für Schichtdicken unter ca. 10 µm werden meist Metalle verwendet. Für Offsetdruckplatten können eingesetzt werden: mechanisch oder elektrochemisch aufgerauhtes und ggf. anodisiertes Aluminium, das zudem noch chemisch, z. B. mit Polyvinylphosphonsäure, Silikaten oder Phosphaten, vorbehandelt sein kann, außerdem Mehrmetallplatten mit Cu/Cr oder Messing/Cr als oberster Schicht. Für Tiefdruck- oder Siebdruckformen eignen sich die erfindungsgemäßen Schichten durch ihre gute Haftung und Ätzfestigkeit auf Kupfer- bzw. Nickel-Oberflächen. Ebenso lassen sich die erfindungsgemäßen Gemische als Photoresists verwenden, wofür sie wegen ihrer guten Lagerfähigkeit in Lösung besonders geeignet sind.

Die Beschichtung kann direkt oder durch trockene Schichtübertragung vom temporären Träger erfolgen auf Leiter plattenmaterialien, die aus Isolierplatten mit ein- oder beidseitiger Kupferauflage bestehen, auf Glas oder Keramik-Materialien, die ggf. haftvermittelnd vorbehandelt sind, und auf Silizium-, Siliziumoxid- und Siliziumnitrid-Scheiben.

Für die Trocknung nach der Beschichtung können die üblichen Geräte und Bedingungen übernommen werden. Temperaturen um 100°C und kurzfristig bis 120°C werden ohne Einbuße an Strahlungsempfindlichkeit vertragen.

Zum bildmäßigen Belichten können die üblichen Kopiergeräte wie Röhrenlampen, Xenonimpulslampen, metallhalogeniddotierte Quecksilberdampf-Hochdrucklampen und Kohlenbogenlampen verwendet werden. Die Belichtung kann auch mit kohärentem Licht eines Lasers erfolgen. Geeignet für die Zwecke vorliegender Erfindung sind leistungsgerechte kurzwellige Laser, beispielsweise Argon-Laser, Krypton-Ionen-Laser, Farbstoff-Laser und Helium-Cadmium-Laser, die zwischen 300 und 600 nm emittieren. Der Laserstrahl wird

mittels einer vorgegebenen programmierten Strich- und/oder Raster-Bewegung gesteuert.

Das Bestrahlen mit Elektronenstrahlen ist eine weitere Bebilderungsmöglichkeit. Elektronenstrahlen können das erfindungsgemäße Gemisch wie auch viele andere organische Materialien durchgreifend zersetzen und vernetzen, so daß ein negatives Bild entsteht, wenn die unbestrahlten Teile durch Lösungsmittel oder Belichten ohne Vorlage und Entwickeln entfernt werden. Bei geringerer Intensität und/ oder höherer Schreibgeschwindigkeit des Elektronenstrahls bewirkt dagegen der Elektronenstrahl eine Differenzierung in Richtung höherer Löslichkeit, d. h. die bestrahlten Schichtpartien können durch den Entwickler entfernt werden.

Die bildmäßig belichtete oder bestrahlte Schicht kann mit den gleichen Entwicklern wie für die bekannten Schichten auf Basis säurespaltbarer Verbindungen behandelt werden, bzw. die neuen Schichten können in ihren Kopierbedingungen vorteilhaft auf die bekannten Hilfsmittel wie Entwickler und programmierte Sprühentwicklungsgeräte abgestimmt werden. Die wäßrigen Entwicklerlösungen können z. B. Alkaliphosphate, -silikate oder -hydroxide und ferner Netzmittel sowie kleinere Anteile organischer Lösemittel enthalten. In bestimmten Fällen sind auch Lösemittel-Wasser-Gemische als Entwickler brauchbar. Die Wahl des günstigsten Entwicklers kann durch Versuche mit der jeweils verwendeten Schicht ermittelt werden. Bei Bedarf kann die Entwicklung mechanisch unterstützt werden.

Zur Erhöhung der Widerstandsfähigkeit beim Druck sowie der Resistenz gegen Auswaschmittel, Korrekturmittel und durch UV-Licht härtbare Druckfarben können die entwickelten Platten kurze Zeit auf erhöhte Temperaturen erwärmt werden, wie es für Diazoschichten aus der GB-A 1 154 749 bekannt ist. Auch eine Bildumkehr nach dem Verfahren der EP-A 0 082 463, entsprechend US-A 4 506 006, ist möglich.

Erfindungsgemäß wird ferner ein Verfahren zur Herstellung von Reliefbildern vorgeschlagen, bei dem man ein strahlungsempfindliches Aufzeichnungsmmaterial aus einem Schichtträger und einer strahlungsempfindlichen Aufzeichnungsschicht, die aus dem erfindungsgemäßen strahlungsempfindlichen Gemisch besteht, bildmäßig mit aktinischer Strahlung in solcher Dosis bestrahlt, daß die Löslichkeit der Schicht in einem flüssigen Entwickler zunimmt, und bei dem man die bestrahlten Schichtbereiche mittels eines wäßrig-alkalischen Entwicklers auswäscht.

Die folgenden Beispiele dienen zur näheren Erläuterung der Erfindung ohne sie hierauf zu beschränken.

Beispiel 1

Das nach J. org. Chem. 25; 258 (1960) hergestellte Dimethylmalondialdehydtetraethylacetal wurde mit der vierfach molaren Menge an Phenoxyethanol mit Toluolsulfonsäure als Katalysator erhitzt und das entstehende Ethanol über eine Kolonne abdestilliert. Der Kolbenrückstand und das bis Kp 77 °C übergangene Destillat entsprechen mengenmäßig einer Umsetzung von 74 %. Nach Verrühren mit wasserfreier Soda zur Neutralisation und Filtration wurde im Vakuum weiter fraktioniert destilliert bis schließlich bei 1,3 Torr und ca. 80 °C nichts mehr überging. Der Kolbenrückstand ($n_D$ = 1 ,5493) ist ein hellgelbes Öl und wurde in folgender Schicht eingesetzt unter Variation ihres Anteils bezogen auf Gesamtfeststoff von 20 bis 40 % mit 5 % Abstufung. Die Stammlösung, zu der die Prüfsubstanzen in den angegebenen Mengen zugesetzt wurden, bestand aus

| | |
|---|---|
| 52 Gt | Lösemittel 1-Methoxypropanol-2 |
| 35 Gt | eines Kresol-Formaldehyd-Novolaks mit dem Erweichungsbereich 105 - 120° C nach DIN 53181, |
| 3,1 Gt | Polyethylacrylat-Homopolymerisat (Plexisol B 574 von Röhm) |
| 0,25 Gt | 2-(4-Styrylphenyl)-4,6-bis-trichlormethyl-s-triazin und |
| 0,15 Gt | Kristallviolettbase (C.I. 42 555:1). |

Die Zugabe von 9,5 Gt der oben beschriebenen Substanz entspricht 20 % an Feststoff. Die Viskosität dieser Beschichtungslösung beträgt etwa 220 mPa•s. Sie wurden eingesetzt für die Herstellung von Feinleiterplatten durch Walzenantrag, z.B. mit einem handelsüblichen Walzen-antragsgerät (roller-coater), Typ AKL 400, der Firma Bürkle, zur doppelseitigen Beschichtung, das mit Gummi-Riffelwalzen mit 48 oder

64 Rillen je 2,5 cm (linear) ausgestattet ist. Je nach Lösung, Riffelwalze und Maschineneinstellungen kann man durch einmaligen Antrag Trockenschichtdicken von etwa 3 bis 14 µm erhalten.

Nach dem Trocknen wird die Platte zunächst unter einer negativen Vorlage, die an den Lochbereichen transparent ist, belichtet, dann werden mit 1 ,5 %-iger Natronlauge diese Bereiche ausgewaschen. Die Platte wird 10 Minuten bei 80 °C getrocknet, dann an den freigelegten Lochbereichen galvanisch mit Kupfer verstärkt und verzinnt.

Danach wird die Photoresistschicht unter einer positiven Leiterbahn-Vorlage belichtet und wie oben entwickelt. Das freigelegte Kupfer wird mit einem alkalischen Ätzmittel weggeätzt.

Bei 6 µm Schichtdicke und 25 % Acetalgehalt wurden für saubere Aufentwicklung 4 min, bei 35 % 1 min benötigt, bei einer Entwicklerresistenz von über 15 min. Während die Schicht mit 20 % relativ hart bis spröde wirkt, macht die mit 40 % Acetalgehalt einen weicheren flexiblen Eindruck und ist für flexible Basismaterialien z. B. für Multilayer-Innenlagen besser geeignet.

Ähnliche Ergebnisse werden erhalten, wenn man ausgeht vom gemischten Acetal aus Isobutylenethylether und Orthoameisensäuremethylester. Für das Endprodukt der Umacetalisierung mit Phenoxyethanol war ohne Belang, ob Methanol oder Ethanol abgespalten wurde.

Beispiel 2

Für die Herstellung einer Offsetdruckplatte wird auf drahtgebürstetes Aluminium eine Beschichtungslösung aufgetragen aus

6,9 Gt Novolak wie in Beispiel 1

2,7 Gt des Tetraacetals ($n_D$ = 1,421) aus Ethylglykol (Ethoxyethanol) und Methylethylmalondialdehyd-tetramethylacetal ($n_D$ = 1,4255). Dieses Produkt war hergestellt aus 2-Methylbutyraldehyd ($n_D$ = 1,3982) über die Zwischenstufe 2-Methylbutenylmethylether ($n_D$ = 1,411)

0,3 Gt 2-(4,7-Dimethoxy-naphth-1-yl)-4,6-bis-trichlormethyl-s-triazin und

0,1 Gt 4-Dimethylamino-azobenzol in

90,0 Gt 1-Methoxypropyl-2-acetat

Die Lösung wird anschließend zu einer homogenen Schicht mit einem Schichtgewicht von 2,2 g/m² entsprechend ca. 2 µm Dicke getrocknet.

Nach dem Trocknen wird unter einer positiven Vorlage belichtet, mit einer 3,5 %igen wäßrigen Lösung von Trinatriumphosphat entwickelt, die durch Zugabe von Natriumhydroxid auf ein pH von 12,6 eingestellt ist, dann mit Wasser abgespült und schließlich die Platte durch Überwischen mit 1 %iger Phosphorsäure druckfertig gemacht. Diese Platte zeigt schnelle Annahme der Druckfarbe und scharfe Bildwiedergabe.

Zum Vergleich wurden Schichten analog hergestellt und verarbeitet, welche statt des eingesetzten Acetals das Tetramethylacetal bzw. den vorherstehenden Enolether enthielten.

Dieser 2-Methylbutenylmethylether, auch charakterisiert im IR-Spektrum durch die Enolether-Vinyl-Protonen Bande bei 1670 $cm^{-1}$, führt auch nach 30 min Behandlung im Entwickler zu keinem Bild der Vorlage. Das daraus hergestellte Tetramethylacetal, das obige Bande nicht mehr enthält, benötigt, kurz nach der Belichtung entwickelt, 3 min bis zur schleierfreien Aufentwicklung. Wurde erst 2 Stunden nach dem Be lichten entwickelt, so war erst nach 10 min Entwickeln ein deutliches Bild zu sehen. Dies wird damit erklärt, daß das an den belichteten Stellen durch katalytische Acetalspaltung entstandene Methanol

inzwischen größtenteils aus der Schicht verdunstete. Das in diesem Beispiel verwendete Acetal mit Ethylglykol als Alkoholkomponente führte dagegen zu einer guten Differenzierung nach 1 min Entwickeln. Ähnliche Ergebnisse werden erhalten, wenn das analog durch Umacetalisieren mit Butylglykol (n-Butoxyethanol) erhaltene Produkt eingesetzt wird, die Aufentwicklung ist dabei mit ca. 20 min etwas langsamer.

## Beispiel 3

Auf eine mit ITO (Indium-Zinn-Oxid) durch Sputtern leitfähig transparent beschichtete Glasplatte für die Herstellung von Flüssigkristall-Anzeigeelementen (LCD) wird durch Schleuderbeschichtung eine lichtempfindliche Schicht folgender Zusammensetzung aufgetragen:

| | |
|---|---|
| 60 Gt | eines Copolymeren aus 4-Hydroxystyrol und Hexylmethacrylat (OH-Zahl 290, RSV-Wert 0,55 dl/g in Dimethylformamid), |
| 19,0 Gt | des Tetraacetals aus Ethoxyethanol und dem Diethylmalonaldehydmethylacetal, das ausgehend vom 2-Ethylbutyraldehyd hergestellt wurde, |
| 0,5 Gt | 2-Acenaphth-5-yl-4,6-bis-trichlormethyl-s-triazin |
| 0,25 Gt | Solvent Blue 5 (C.I. 61554) |
| 0,25 Gt | Kristallviolettbase |
| 120 Gt | 1-Methoxypropanol-2. |

Nach dem Trocknen ist die Schicht ca. 4 µm dick. Sie wird nach Belichten unter einer positiven Vorlage in 1 %iger Natronlauge in 40 sec entwickelt und an den freigelegten Stellen mit 5 %iger Kalilauge gestrippt. Man erhält so elektrisch leitfähige, transparente Platten z.B. für eine 7-Segment-Ziffernanzeige. Die blaue Grundeinfärbung dient der Verstärkung des Bildkontrasts bis zur Ätzung.

Wird anstelle obiger Substanz das Tetraacetal aus 2-Ethylbutanol eingesetzt, so verlängert sich die Entwicklungszeit auf 70 sec. Das analog ebenfalls hergestellte Produkt ($n_D$ = 1,423) mit Phenoxyethanol benötigt 50 sec zum Entwickeln bei sehr guter Entwicklerresistenz. Auch bei Einsatz von 40 Gt (anstelle 19,5 Gt) dieser Substanz ist in 30 min die relativ weiche Schicht noch sauber bildmäßig zu differenzieren.

## Beispiel 4

Es werden Positiv-Farbfolien z.B. für die Montagekontrolle im Mehrfarben-Offsetdruck hergestellt. Dazu werden mit höheren Alkyl-Substituenten und Alkoholen hergestellte Malonaldehydacetale eingesetzt, welche gut differenzierbare, weiche und übertragbare Farbschichten liefern. Zur Herstellung genügt nach der Reindestillation der Enolether und Umsetzung mit Orthoameisensäuremethylester und dem Umacetalisieren mit dem höheren Alkohol jeweils das Abziehen der nicht umgesetzten Komponenten im Vakuum, da die unter üblichen Bedingungen kaum bzw. nicht mehr destillier baren Dialkylmalondialdehyd-tetraacetale als öliger Rückstand direkt eingesetzt werden können.

Näher untersucht wurde für dies Beispiel das Malonacetal ausgehend vom 2-Ethylhexanal und Phenoxyethanol. Dabei wurde der Enolether mit Kp 173 - 182 °C noch reindestilliert, die Ethyl-butylmalondialdehydtetraacetale aber nicht.

Die Kopierschichten haben die Zusammensetzung:

| | |
|---|---|
| 45 Gt | des vorstehenden Tetraacetals |
| 48 Gt | Novolak wie in Beispiel 1 |
| 5 Gt | Polyvinylmethylether (Lutanol M 40) |
| 0,5 Gt | 2,5-Diethoxy-4-p-tolylmercapto-benzol-diazoniumhexafluorphosphat, |
| 2,5 Gt | Zaponechtblau HFL (C.I. 2880) oder |
| 1,2 Gt | Zaponechtrot BB (C.I. 2864) oder |
| 2,0 Gt | Fettgelb 5 G (C.I. Suppl. 572). |

Die Schichtdicken zwischen 1 und 3 µm auf 50 µm Polyesterfolie und die Farbstoffmengen werden so aufeinander abgestimmt, daß die Rot-, Blau- und Gelbfolie die gleiche Lichtempfindlichkeit aufweisen, d.h. bei sowohl gleicher Belichtungszeit als auch Entwicklungszeit mit 0,5 % Natronlauge gleich lange Keilstufen bei einem mitkopierten Halbton-Testkeil ergeben. Diese kratzfesten Farbfolien sind mehr als doppelt so lichtempfindlich wie Vergleichsprodukte auf Basis von o-Naphthochinondiaziden. Außerdem können diese Farbschichten unter Druck und Wärme von der Folie auf Papier übertragen werden, da sie relativ weich und haftend sind. Wird als Alkoholkomponente anstelle des Phenoxyethanols mit Methoxyethoxyethanol (Kp 180 - 196 °C) umacetalisiert, so erhält man nach dem Entwickeln mit 0,4 %iger Natronlauge als Entwickler ähnliche Ergebnisse.

## Ansprüche

1. Positiv arbeitendes strahlungsempfindliches Gemisch, das als wesentliche Bestandteile
a) eine bei Bestrahlung eine starke Säure bildende Verbindung,
b) eine Verbindung mit mindestens einer durch Säure spaltbaren C-O-C-Bindung, wie ein Acetal und
c) ein in Wasser unlösliches, in organischen Lösemitteln und in wäßrig-alkalischen Lösungen lösliches oder quellbares Bindemittel
enthält, dadurch gekennzeichnet, daß das Acetal eine Verbindung der allgemeinen Formel

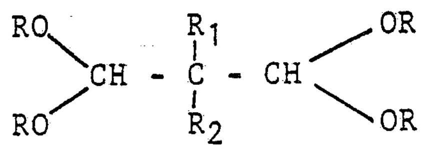

ist, worin
R eine gegebenenfalls substituierte Alkylgruppe und
$R_1$ und $R_2$ gleich oder verschieden sind und Alkylgruppen mit 1 bis 6 Kohlenstoffatomen bedeuten.

2. Gemisch nach Anspruch 1, dadurch gekennzeichnet, daß das Acetal eine Verbindung der allgemeinen Formel darstellt, worin
R eine durch Alkoxyl, Aryl, Aryloxyl oder Polyalkoxyl substituierte Alkylgruppe mit insgesamt jeweils 2 bis 20, vorzugsweise 2 bis 10 Kohlenstoffatomen und
$R_1$ und $R_2$ gleich oder verschieden sind und Alkylgruppen mit 1 bis 4 Kohlenstoffatomen bedeuten.

3. Gemisch nach Anspruch 1 oder 2, dadurch gekennzeichnet, daß es 25 bis 60 Gewichtsprozent, bezogen auf Gesamtfeststoff, an Acetal enthält.

4. Gemisch nach Ansprüchen 1 bis 3, dadurch gekennzeichnet, daß es 30 bis 80 Gewichtsprozent, bezogen auf Gesamtfeststoff, an wasserunlöslichem Bindemittel enthält.

5. Gemisch nach Ansprüchen 1 bis 4, dadurch gekennzeichnet, daß es 0,1 bis 10 Gewichtsprozent, bezogen auf Gesamtfeststoff, an einer Verbindung enthält, die unter Einwirkung von aktinischer Strahlung eine starke Säure bildet.

6. Strahlungsempfindliches Aufzeichnungsmaterial aus einem Schichtträger und einer strahlungsempfindlichen Aufzeichnungsschicht aus einem Gemisch nach Anspruch 1.

7. Verfahren zur Herstellung von Reliefbildern bei dem man ein strahlungsempfindliches Aufzeichnungsmaterial nach Anspruch 6 bildmäßig mit aktinischer Strahlung in solcher Dosis bestrahlt, daß die Löslichkeit der Schicht in einem flüssigen Entwickler zunimmt, und daß man die bestrahlten Schichtbereiche mittels eines wäßrig-alkalischen Entwicklers auswäscht.